# EUROPEAN PATENT APPLICATION

(11) **EP 0 801 413 A1**
(43) Date of publication of application: **15.10.1997**
(21) Application number: 97301602.5
(22) Date of filing: 11.03.1997
(51) Int. Cl.: H01J 37/32

(54) **Inductively coupled plasma reactor with faraday-sputter shield**

(30) Priority: 12.03.1996 US 614980
(71) Applicant: VARIAN ASSOCIATES, INC., Palo Alto, California 94304 (US)
(72) Inventor: Lai, Kwok Fai, Palo Alto, CA 94303 (US); Drewery, John, Alameda, CA 94501 (US)
(74) Representative: Cline, Roger Ledlie

(57) **Abstract**

A slotted Faraday-sputter shield is formed to provide no line-of-sight paths therethrough. The Faraday-sputter shield is preferably finished on its outer surface with a smooth highly electrically conductive finish, and on its inner surface with a rough surface to aid in adhering material deposited during plasma processing. The shield may be arranged in an inductively coupled plasma reactor having an RF powered coil disposed external to a plasma chamber, a plasma powered by the coil to be formed within the dielectric chamber, the shield being disposed within the chamber between the plasma and the RF coil to provide no line-of-sight paths between the plasma and the RF coil while permitting inductive but no capacitive coupling between the RF coil and the plasma.

## Description

The present invention is directed to an apparatus for use in processing semiconductor devices and the like. More particularly, the present invention is directed to novel plasma sputter deposition (PSD) reactor designs and plasma etch and deposition designs which incorporate an external (to the plasma-containing chamber) inductive plasma source and an internal (to the plasma-containing chamber) Faraday-sputter shield. Optionally, the Faraday-sputter shield is made self-cleaning.

In processing semiconductor wafers to form integrated circuits thereon, plasma-assisted processes are frequently used for depositing materials onto and etching materials from the semiconductor wafer. Such processes include plasma etching, reactive ion etching (RIE), plasma enhanced chemical vapor deposition (PECVD), as well as a number of other well known processes. In order to form and power such a plasma, a radio frequency (RF) power source is generally used to provide power to one or more powered electrodes within a vacuum vessel containing a gas at a predetermined pressure in which the processing is to take place. A matching network is typically used to efficiently couple power from the RF power source to the powered electrode within the vacuum chamber interior. The operation and construction of such RF power sources and their matching networks is well known to those of ordinary skill in the art.

The creation of an electric field between electrodes within the vacuum chamber causes electrons present in the gas to initially collide elastically with gas molecules. As this process continues, the electrons gain more energy and eventually begin to collide inelastically with the gas molecules to form excited or ionized species. Eventually a steady state plasma is formed in which excitation and recombination of the atoms with electrons within the plasma are balanced. Highly reactive ions and radical species are produced in the plasma and may be used to etch or deposit materials on semiconductor wafers. Electric and magnetic fields formed within the vacuum chamber either by action of the plasma or by external application of magnetic fields and/or DC or RF self-induced biasing mechanisms are used to control the etching and deposition processes within the vacuum chamber.

Recent trends in the semiconductor industry include requirements for the production of finer and finer device features on larger and larger semiconductor substrates while achieving higher and higher throughput. The goal in the design of semiconductor fabrication equipment is thus to provide equipment capable of rapid processing, low downtime and low levels of contamination and device damage. It is also highly desirable to be able to achieve uniform etching across the relatively large surfaces presented by the 20 cm semi conductor substrates currently in production and the 30cm substrates planned for production in the future. Higher power results in more rapid processing yet leads to problems such as the deposition and etching of materials to and from undesired locations such as the walls of the reactor chamber.

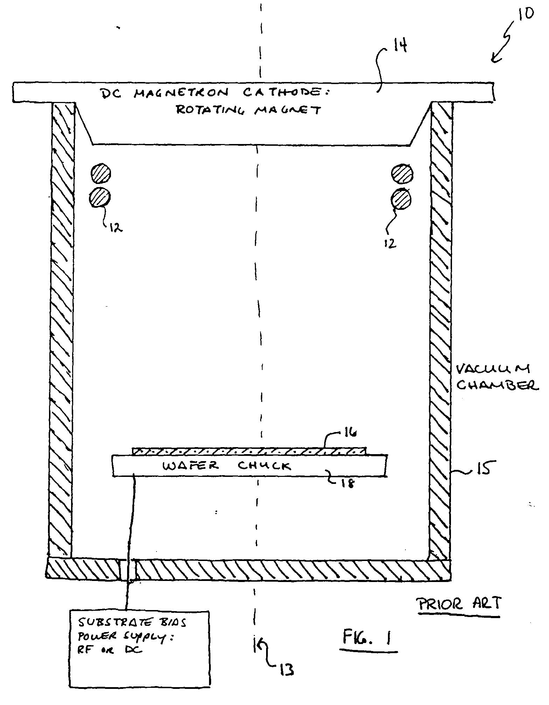

The use of metal ions to deposit metal films for use in semiconductor applications has been studied extensively in recent years. In particular, the IBM Corporation has worked on developing a reactor which uses an inductively coupled RF coil to ionize the sputtered metal neutrals from a planar magnetron. A typical reactor 10 for such experiments is shown in FIG. 1.

As can be seen in FIG. 1, a RF coil 12 was placed inside chamber 15 between the magnetron target cathode 14 (here, a rotating fixed magnet assembly forming a closed-loop magnetic field in the region of the target cathode; magnetron rotation is about the vertical axis 13 of the dielectric reactor vacuum chamber 15) and the wafer 16 on chuck 18 to ionize the sputtered metal atoms from the magnetron target cathode 14. A dense, inductively coupled plasma was generated by applying RF power to the two-turn RF coil 12. Although this approach has been proven by IBM workers to be effective in generating a high density plasma, there are still a number of problems associated with it which preclude it from being a commercially viable technology for use in semiconductor processing at this time.

A significant problem with the IBM approach discussed above is that RF coil 12 is in direct contact with the plasma on the inside of chamber 15. In order to couple significant power to RF coil 12, it must be driven to relatively high RF voltages (on the order of at least a few hundred volts). This high voltage inevitably causes sputtering of RF coil 12 itself due to the high density plasma that it generates and therefore contacts. Sputtering of the coil when the coil is of a material other than the cathode target (i.e., sputter source) causes contamination of the deposited film with the material of the coil. This outcome is unacceptable. One solution to this problem is to make the RF coil itself out of the same material as the sputter source. While somewhat convenient for depositing certain materials, this approach is inconvenient for materials such as those having a high resistivity such as, for example, Titanium (Ti) and Tungsten (W) as it will lower the Q of the RF circuit making it more difficult to couple energy into the plasma. It is also generally a relatively expensive undertaking to fabricate the RF coil out of the high purity materials suitable for use in the sputter chamber. Another solution to this problem is to make the RF coil out of a material such as copper (Cu) and then sputter deposit material from the sputter source onto it. In this way, if sputtered, the coil will only yield the source material -- at least for a while. This technique poses the problems of both reducing the Q of the RF circuit as well as requiring careful attention to the level of coating on the RF coil over time.

In both of the above-described arrangements, coil erosion will impose significant limits on the useful life of the RF coil itself. Additional costs are also incurred due to the required periodic replacement of the RF coil prior to failure. Replacing the RF coil requires downtime, is a significant undertaking, exposes the reactor to contamination, and is expensive and undesirable. These arrangements introduce the further disadvantage of particulate contamination where sputtered target material builds up on the coil, then flakes off, potentially striking and damaging the wafer under fabrication at the time.

A further problem arises due to the fact that the RF coil needs to be cooled with an internal water flow in order to remove the heat deposited in the RF coil by contact with the plasma discharge. This structure places a water flow through the RF coil within the reactor chamber in close proximity to a violent plasma discharge which will eventually destroy the RF coil through erosion. Arcing, corrosion and electrolysis problems may all ensue. Additional measures and consequent costs are required to prevent these problems.

Another undesirable characteristic of an internal RF coil is that there is significant capacitive coupling between the RF coil and the plasma. Since a capacitively coupled plasma tends to generate high voltages, arcing, excessive sputtering and non-uniform density profiles of sputtered material across a diameter of the wafer being processed, it is highly desirable to minimize any such coupling.

US-A-5,178,739 discloses a sputter deposition reactor which employs an internal planar coil disposed at one end of the chamber and a cylindrical target from which is sputtered material to be deposited on a substrate disposed at an opposite end of the chamber. While suited for its intended purpose, this design does not avoid the problem of plasma-coil interaction at high input power levels.

A number of additional references discuss the general problems associated with plasma-based sputtering systems. US-A-3,369,991 describes a sputter deposition chamber in which a planar electrode is coupled to an RF power source to form a plasma. US-A-4,126,530 describes a sputter cleaning/etching/coating system utilizing a cylindrical cathode. US-A-5,228,963 describes a hollow cathode magnetron for use in sputter coating long filaments. US-A-5,328,582 describes an off-axis magnetron sputtering apparatus with relative rotary motion between a magnetron target bearing material to be sputter deposited and a substrate to be coated.

US-A-5,431,799 describes another plasma reactor employing an internal RF coil system. US-A-05,433,812 describes a plasma reactor employing an end-type dielectric window and planar RF coil for transformer coupled plasma (TCP) operation. A shield for shunting capacitive electric fields generated by the planar RF coil to ground is provided external to the chamber interior at a position between the RF coil and the dielectric window. The shield operates to reduce capacitively coupled electric fields while having little effect on inductive magnetic fields induced by the RF coil and which are used to power the plasma. A similar structure is shown in Mahoney et al., "Characterization and Organic Film Deposition of a Broad Area, Planar RF Induction Source" (November, 1992 American Vacuum Society Conference, Chicago, Illinois). While suited for their intended purposes, these designs interpose the dielectric wall or window between the shield and the plasma leading to the possibility of forming a metallic (conductive) coating on the inside of the dielectric wall or window of the vacuum chamber if they were to be used for sputter deposition of conductive metal atoms, thus blocking power from the RF coil from having the effect inside the chamber of powering the plasma.

US-A-4,795,879, while not directed to semiconductor wafer fabrication, is mentioned for completeness. It discloses an inductively coupled external RF coil powered plasma jet device. A material to be sputtered is introduced into the chamber of the device. The device is operated to form a plasma. Vapor from the plasma is then expanded out of the chamber and allowed to deposit on a cold collection surface external to the interior of the chamber in order to form an ultrafine and ultrapure powder or coating thereon. Its system preferably uses a pure metal gasless plasma, external RF induction coils and dielectric plasma chamber walls. Shorting of the dielectric chamber walls is avoided by use of an interlocking assembly of vertically slotted, water-cooled, segmented shields which preclude a line-of-sight path between the external RF coil and the plasma inside the chamber. While suited for its intended purpose, this apparatus is not suitable for the fabrication of semiconductor devices within its chamber.

Accordingly, the above references do not provide a high power inductively coupled plasma deposition reactor for depositing thin conductive films upon silicon wafers situated inside a plasma deposition reactor. While fit for their intended purposes, the references set forth above relating to internal coil ICP deposition reactors lack sufficient power handling capabilities to achieve current commercially desirable and practical throughput rates at reasonable cost and percentage downtime; the external coil devices described above do not provide adequate sputter shielding in conjunction with Faraday shielding for semiconductor wafer fabrication inside a thin film deposition reactor structure with adequate power handling capabilities at commercially practical throughput rates, reasonable cost and acceptable percentage downtime.

The invention is set out alternatively in the independent claims

The present invention is applicable to plasma reactors for use in semiconductor processing having dielectric vacuum envelopes used for depositing or etching thin films upon semiconductor wafers placed inside the vacuum envelopes for processing. Such reactors utilize plasma assisted processes where the plasma is energized by an RF power source inductively coupled to the interior of the vacuum envelope.

In one arrangement an RF coil or antenna is placed outside a reactor chamber, outside of the vacuum envelope of the reactor chamber and out of direct contact with the plasma. Simultaneously, a slotted grounded or selectively biased Faraday shield is placed inside the vacuum envelope to short all capacitive coupling between the RF coil and the plasma. The Faraday shield also serves as a sputter shield by physically occluding all line-of-sight paths between the plasma and the RF coil thus protecting the inside wall of the vacuum envelope adjacent the RF coil from unwanted deposition of conductive material which could block inductive coupling between the RF coil and the plasma. The Faraday-sputter shield serves to block capacitive coupling between the RF antenna and the plasma inside the vacuum envelope while leaving inductive coupling between the two relatively unaffected. The present invention is adapted for use in a variety of configurations including inductively coupled plasma (ICP) processes and transformer coupled plasma (TCP) processes. It may be used with sputter deposition reactors, other plasma deposition reactors and plasma etchers powered by an external RF coil.

In another arrangement, the Faraday-sputter shield may be provided with an adjustable bias voltage source so as to control deposition build-up on the shield as well as provide a "self-cleaning" capability.

In a further arrangement (not intended for use with the "self-cleaning" option), the shield may be constructed so as to provide the outside of the shield with a smooth highly electrically conductive coating (e.g., gold, silver or copper plating over a smoothed surface) while roughening the surface of the inside of the shield in order to promote more efficient inductive coupling between the RF antenna and the plasma while maximizing the ability of the shield to adhere sputtered material to its inner surface in order to help prevent particulate contamination in the system.

In yet another arrangement, the Faraday-sputter shield can be grounded to the chamber so as to minimize sputtering of its surface during plasma processing. Active cooling of the shield (i.e., by driving a coolant through the shield elements) can also be implemented to allow for very high power operation.

Examples of the prior art and of the invention will now be described with reference to the accompanying drawings in which:
FIG. 1 is a schematic diagram of a typical prior art inductively coupled plasma reactor for plasma etching and deposition.
FIG. 2 is a schematic diagram of a portion of a horizontal cross section of an ICP reactor according to a presently preferred embodiment of the present invention.
FIGS. 2A, 2B, 2C, 2D and 2E are diagrams of horizontal cross sections of five presently preferred shield designs for use with the ICP reactor according to a presently preferred embodiment of the present invention.
FIG. 3 is a schematic diagram of a portion of an ICP reactor and shield in proximity to a plasma discharge shown in horizontal cross section.
FIG. 4 is a top view of an ICP reactor according to a presently preferred embodiment of the present invention.
FIG. 5 is an elevational cross section of an ICP reactor according to a presently preferred embodiment of the present invention.
FIG. 6 is a perspective diagram showing an ICP reactor RF coil, dielectric chamber wall and slotted shield according to a presently preferred embodiment of the present invention.
FIG. 7 is a perspective diagram showing a slotted shield of an ICP reactor according to a presently preferred embodiment of the present invention. drawing of a tailored electrode according to the present invention having a generally conical shape with a reversed conical portion.
FIG. 8 is a diagram of a portion of a horizontal cross section of an ICP reactor according to a presently preferred embodiment of the present invention incorporating a variable DC bias circuit.
FIG. 9 is a schematic diagram of a TCP reactor according to a presently preferred embodiment of the present invention.
FIG. 10 is a top view of a radially slotted planar internal Faraday-sputter shield for use with a TCP reactor according to FIG. 9.
FIG. 11 is a top view of a planar spiral RF coil for use with a TCP reactor according to FIG. 9.
FIG. 12 is a top view of a planar stepped spiral RF coil for use with a TCP reactor according to FIG. 9.
FIG. 13 is a top view of a spoked RF coil for use with a TCP reactor according to FIG. 9.
FIG. 14 is a top view of a spirally slotted planar internal Faraday-sputter shield for use with a TCP reactor according to FIG. 9.
FIG. 15 is a top view of a stepped spirally slotted planar internal Faraday-sputter shield for use with a TCP reactor according to FIG. 9.
FIG. 16 is a side view of a helical RF coil with flattened coil portions disposed against a dielectric window for use with a TCP reactor according to FIG. 9.
FIG. 17 is a top view of a slotted planar internal Faraday-sputter shield for use with a TCP reactor according to FIG. 9 and the RF coil arrangement of FIG. 16.
FIG. 18 is a system block diagram for a plasma reactor according to a presently preferred embodiment of the present invention.

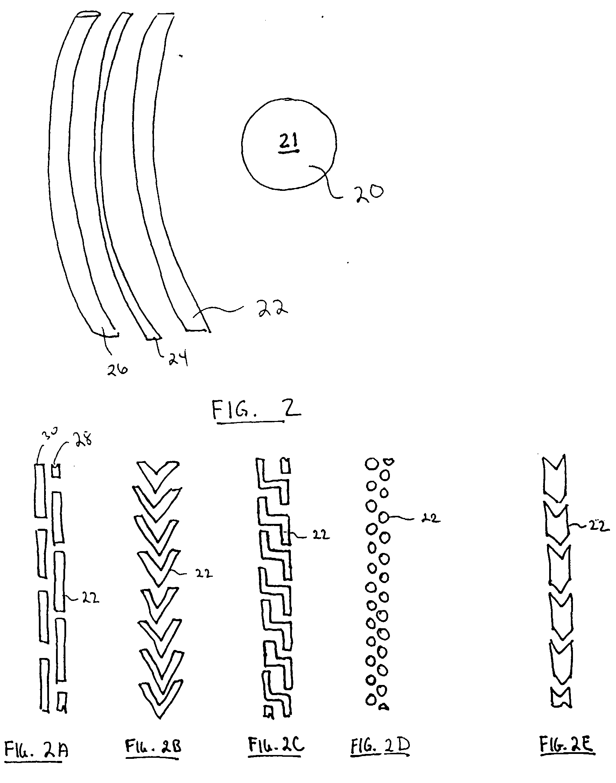

FIG. 2 is a schematic diagram of a portion of a horizontal cross section of an ICP reactor according to a first presently preferred embodiment of the present invention incorporating the new RF coil or antenna design. As can be seen in FIG. 2 which is a partial top view of the reactor chamber, plasma discharge 20 in a plasma forming region 21 is surrounded by shield structure 22 which is, in turn, surrounded by dielectric chamber wail 24 ("outer wall"). Wall 24 is preferably formed of fused quartz or another suitable high temperature vacuum compatible material with low RF attennuation such as, for example, alumina. RF coil 26 is coiled about dielectric chamber 24 as shown.

According to a presently preferred embodiment of the present invention in the form of a sputter deposition reactor, the reactor is to be operated at an input power in excess of one kilowatt. The exciting RF energy is preferably in a range of from about 100 KHz to about 2000 KHz or higher. The RF coil or antenna may be air or liquid cooled. Air cooling is simpler and is presently preferred. The pressure of the reactor chamber is maintained in a range of from about 0.0133 Pa to 13.3 Pa of Ar with about 0.026 Pa required to achieve a self-igniting plasma. Nitrogen gas may be introduced as well to achieve TiN deposition as well known to those of ordinary skill in the art. It is presently preferred to employ a rotating fixed magnet magnetron at the sputter target, although a magnetron is not required. The rotating magnetron is desirable to achieve uniform target usage as is well known to those of ordinary skill in the art. Sputter targets of materials to be deposited are contemplated for use with the present invention. These include, but are not limited to, titanium (Ti), titanium-tungsten (TiW), copper (Cu), aluminum (Al), and the like. Non-conductive materials may also be deposited. Furthermore, other plasma reactor configurations may be used other than sputter deposition configurations as will appear to those of ordinary skill in the art.

A number of configurations are possible for shield structure 22. Some of these are shown in FIGS. 2A, 2B, 2C, 2D and 2E which are diagrams of horizontal cross sections of five presently preferred shield designs for use with the ICP reactor of the present invention. FIG. 2A is presently preferred for use by the inventors and is a double slotted shield with the shield elements of the inner shield 28 offset from the slots of the outer shield 30 so as to preclude any line-of-sight paths between plasma 20 and RF coil 26. FIGS. 2B - 2E show other possible arrangements which should work as well. Additionally, if desired, cooling channels may be provided in the shield elements to allow coolant to flow between top and bottom of the shield elements so as to further cool the shield elements and permit the use of higher power plasmas. Such a scheme is shown and described in US-A-4,795,879 and hereby incorporated herein by reference as if set forth fully herein.

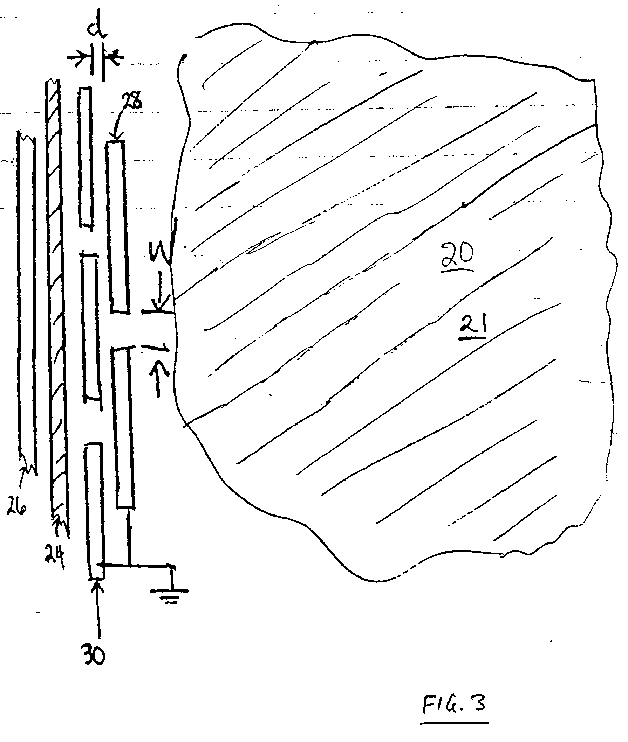

As shown more clearly in FIG. 3 which is a schematic diagram of a portion of an ICP reactor and shield in proximity to a plasma discharge shown in horizontal cross section, the double vertically slotted cylindrical shield of FIG. 2A is effective in protecting the dielectric cylinder 24 from conductive deposition contaminants as long as the mean free path (MFP) of the metal atoms (i.e., those in the plasma) is much longer than the spacing, d, between the two shield layers 28 and 30. Note that the slot width, W, is not a critical dimension as long as there is sufficient overlap between the shields 28 and 30 to achieve the no line-of-sight path condition between the plasma and the RF coil. Also note that the MFP of an atom, such as a sputtered metal atom in the plasma, is a function of the gas pressure in the reactor. Thus, at about 0.133 Pa. of Ar, a Ti atom's MFP is on the order of 1 cm, but at 1.33 Pa of Ar, the MFP drops to about 1 mm.

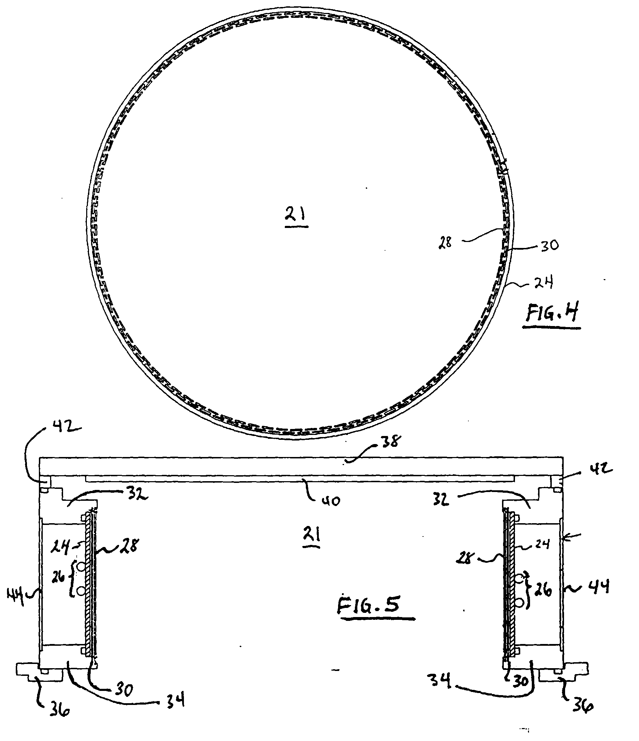

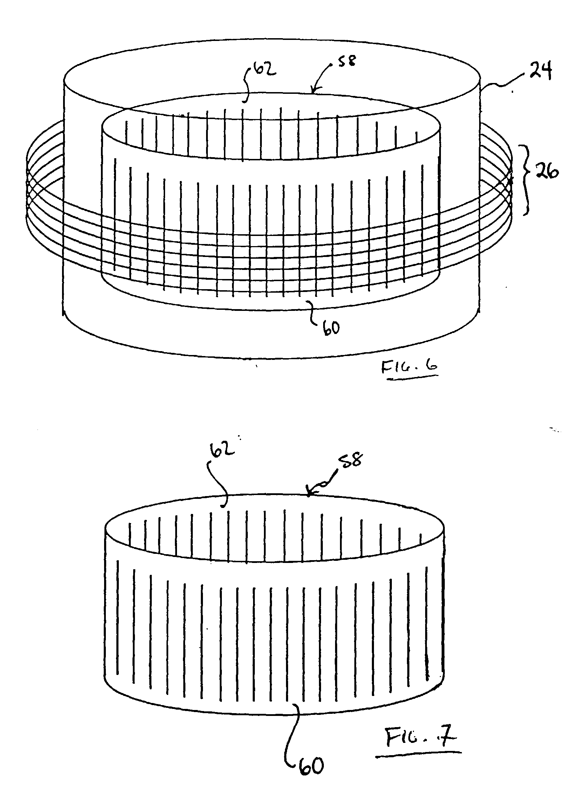

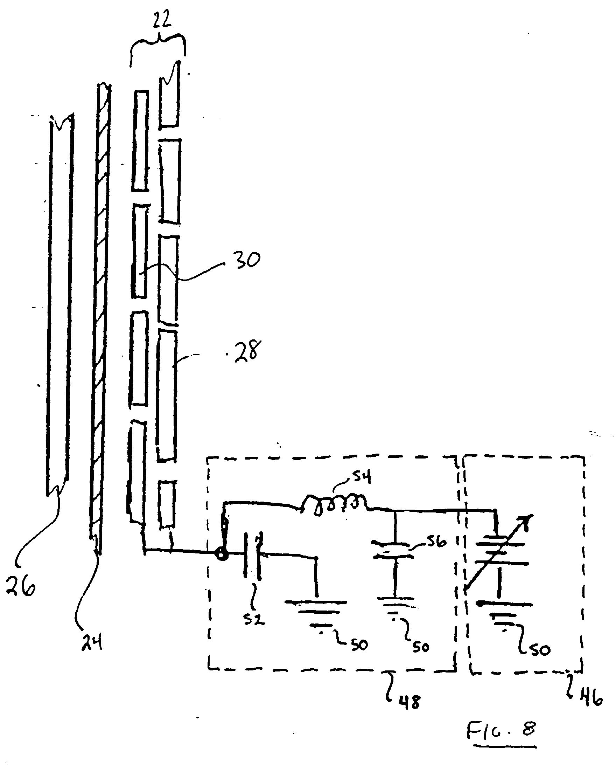

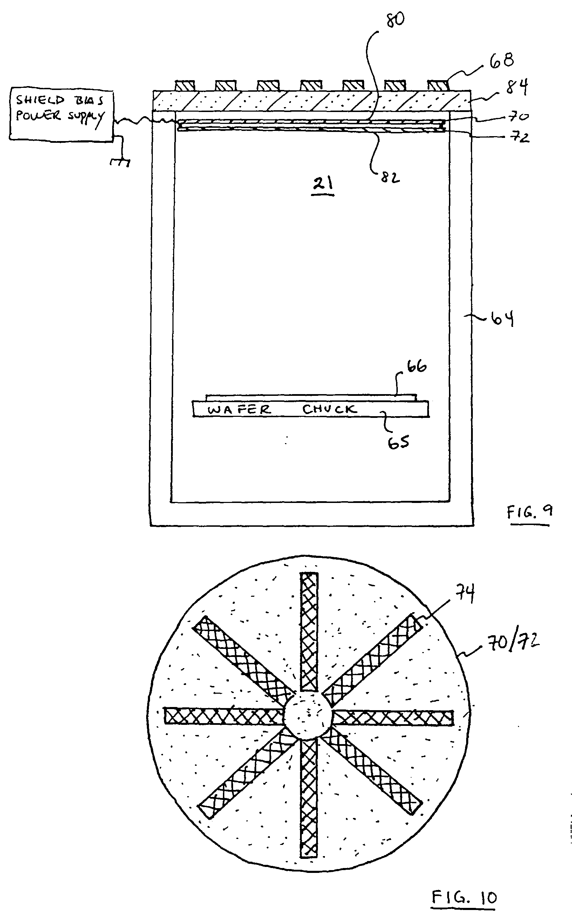

FIG. 4 is a top view of an ICP reactor according to a presently preferred embodiment of the present invention showing the arrangement of the two shields 28 and 30 to form a double vertically slotted shield structure.

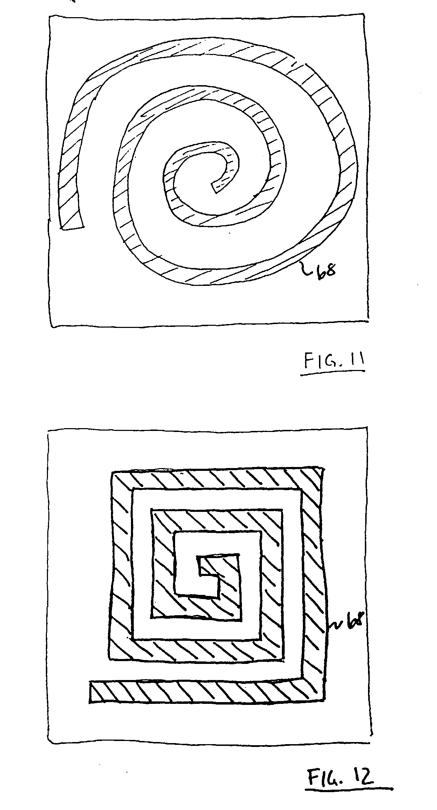

FIG. 5 is an elevational cross section of an ICP reactor according to a presently preferred embodiment of the present invention. Besides implementing the double vertically slotted shield as discussed above, there are also several other innovative features in this design. An upper and a lower adapter end flange (32, 34, respectively) are used to provide vacuum seals between the dielectric cylinder 24 and the other portions of the reactor chamber. It is presently preferred to fabricate the adapters of aluminum. In FIG. 5 lower aluminum adapter flange 34 is shown sealing dielectric cylinder 24 to reactor chamber flange 36. Similarly the magnetron target assembly 38 forms a cover of the reactor chamber and includes magnetron target 40 and a ceramic insulator 42 to which upper aluminum adapter flange 32 seals dielectric cylinder 24.

Aluminum adapter flanges 32, 34 also serve as electrical conductors to ground the shields 28, 30 to the chamber wall and may be used to aid in supporting the weight of the upper portion of the chamber assembly, including the magnetron target assembly 38, if desired. The spacing between the two aluminum adapter flanges 32, 34 is determined by: (1) the outer ground shield 44 (which serves as the return RF current path of the shields 28, 30 and as a radiation shield for the RF coils 26 for purposes of reducing RF interference emitted to the environment); (2) by insulating standoffs between them; or (3) by the height of the dielectric cylinder 24. With design Nos. 1 or 2 above, the wall thickness of the preferably quartz dielectric cylinder 24 can be minimized (preferably to about 6 mm) as it only needs to be structurally capable of handling one atmosphere of pressure from inside to outside (vacuum to room pressure) but not the weight of the entire magnetron target assembly 38 which is preferably at least partly supported by ground shield 44. Reducing the distance from the RF coil to the plasma produces better coupling of power into the plasma within the reactor. The ground shield 44 serves as the return RF current path of the shields 28, 30 and as a radiation shield for the RF coils for purposes of reducing RF interference emitted to the environment.

The Faraday-sputter shield structure 28, 30 essentially eliminates capacitive coupling between the RF coil and the plasma by providing an electrical short that prevents the capacitive component of the field caused by the RF coil from propagating to the inside of the Faraday-sputter shield.

The present invention may also be used for the deposition and etching of non-conducting materials as well as conducting materials. A problem with using an inductively coupled plasma (ICP) source to deposit or etch non-conducting materials is that it generally results in deposition of such materials on the quartz wall of the vacuum envelope as well. Without the frequent use of special decontamination procedures on the dielectric cylinder (e.g., bead blasting, acid dipping) such materials will quickly build up and begin to flake off due to poor adhesion of such materials to the smooth dielectric cylinder. Such procedures require disassembly of the reactor and removal and/or replacement of the reactor envelope. This inevitably causes a risk of particulate contamination of the products being fabricated in the chamber. The use of an internal shield as described above essentially completely protects the dielectric cylinder from the deposited materials at the cost of sacrificing the shield after a certain period of time. Such metal shields, particularly when their surfaces are roughened, adhere sputtered materials much better than do quartz walls resulting in longer periods of time between necessary down time to open the chamber to clean and/or replace necessary parts. Such shields are much more easily replaced than the dielectric cylinder is cleaned, accordingly, such shields may be used in a somewhat similar fashion to the sputtering shields which are presently commonly used in Physical Vapor Deposition (PVD) reactors.

Since the internal shield is electrically conductive, it can be biased. Such biasing can be used to reduce deposition of materials onto the shield, extending the used life of the shields. Such biasing cannot be used on the dielectric cylinder because it is non-conductive. According to a presently preferred embodiment of the present invention, a variable DC bias 46 is applied to the internal shield 22 with conventional DC bias coupling circuit 48 as shown in FIG. 8. Preferably, instead of connecting the shield directly to the ground 50 of the system, the shield is connected through an RF capacitor 52 to ground 50. A low pass filter 54, 56 designed to allow the DC bias to bias the shield without allowing the RF into the bias power supply is used to connect variable DC bias power supply 46 to the shield. The separation of the RF and DC grounding of the shield allows the biasing of the shield at any desired DC potential as selected by bias supply 46. By controlling the bias on the shield, the rate of deposition and etching (by sputtering of ions) of the deposited materials can be balanced or nearly balanced. An ideal situation is to make the net deposition rate just slightly greater than the etched rate everywhere on the shield. This condition would greatly prolong the useful life of the shield.

Where etching is involved, it may not be desirable to transport the etched material back to the substrate. For such applications, an in-situ cleaning cycle can be used between process cycles. That is, the shield would be grounded during regular etching to allow the deposition of the etched material onto the shield. During the cleaning cycle, the shield would be biased to a negative potential in order to enhance ion bombardment and sputtering. A reactive gas (e.g., H₂ for oxide removal) can be used to convert the etched materials to volatile gasses that can then be pumped away. Since the same ICP source is used for the generation of the plasma, no extra electrodes or RF power supplies are needed to activate the in situ cleaning step. More uniform cleaning will result as the same source is used for both etching and cleaning. Shorter cleaning cycles are possible over prior art systems dependent upon a glow discharge power source for the in situ cleaning step as ICP has a higher plasma density than such a glow discharge.

The shield of the present invention can be designed in a number of ways to facilitate optimization for a particular application. FIGS. 2A - 2E depict a number of different cross sectional designs for such shields. As long as the MFP of the atoms is much longer than the spacings d (in FIG. 3) between the slots of the shields, all of these designs should work equally well.

While this invention has been disclosed in terms of the use of a cylindrical dielectric vacuum chamber using ICP to form a plasma discharge, other configurations would also work and are intended to be covered by the appended claims. For example, a non-cylindrical domed or truncated-conical chamber wall could be used. Similarly, while cylindrical shields are shown, there is no requirement that the shield be cylindrical for use in ICP, but could be any generally hollow tubular structure having slots where the structure blocks all line of sight paths from its center or vertical axis to its outside or outer surface.

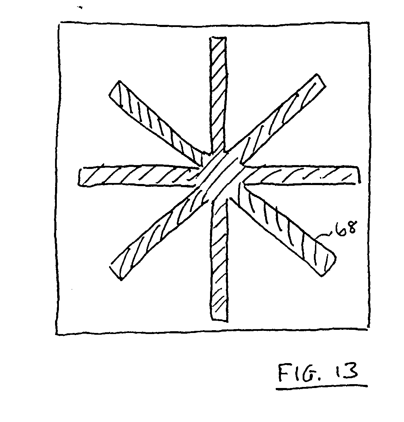

Turning now to FIGS. 9 - 17, an arrangement for using the present invention with transformer coupled plasma (TCP) reactors is depicted. In this arrangement a reactor chamber 64 is provided which encloses a wafer chuck 65 on which may be disposed a wafer 66 to be processed. An RF signal may be inductively coupled into the chamber 64. To do so, an RF coil/antenna 68 which may be planar and is disposed adjacent to dielectric window 84 which is preferably essentially RF transparent and formed of alumina, quartz, or another suitable high temperature vacuum material. A Faraday-sputter shield 70/72 is formed of a pair of flat elements 70, 72 which fit within chamber 64 and include slots which are offset so as to preclude any line-of-sight paths from the plasma forming region within the chamber 64 to window 84.

In order to maximize inductive coupling while minimizing capacitive coupling, the coils and slots should be oriented perpendicular to one another as much as is practical. Since the slots and coils cannot be in the same plane, "perpendicular" here means perpendicular as viewed along an axis orthogonal to the dielectric chamber wall 24 or dielectric window 84. For example, in one preferred embodiment, coil 68 is a spiral arrangement as shown in FIG. 11 or a stepped spiral arrangement as shown in FIG. 12 while shield 70/72 is formed of a pair of offset disks configured with radially (or spoked) oriented slots 74 as shown in FIG. 10.

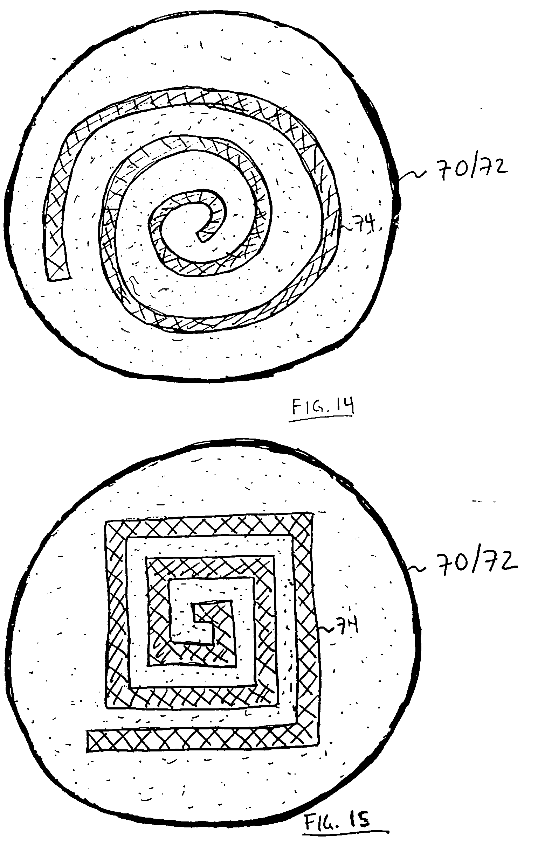

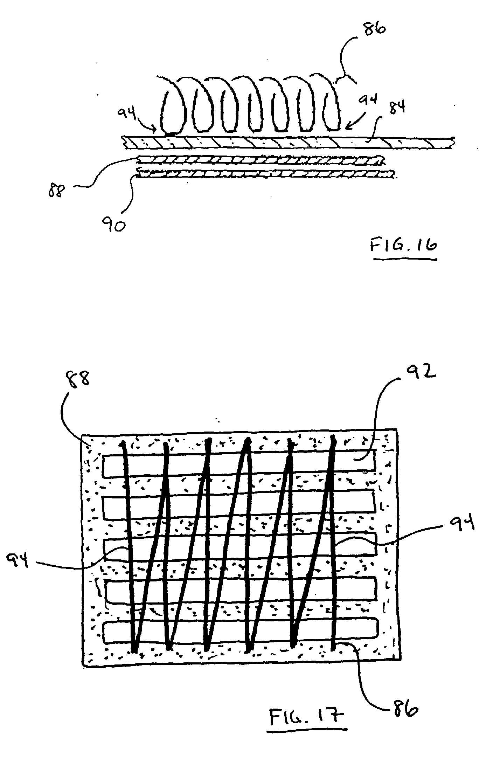

In another preferred embodiment, a radially (or spoked) oriented antenna 68 as depicted in FIG. 13 may be used with a spirally slotted pair of offset shields 70/72 as shown in FIG. 14 or with a stepped spirally slotted pair of offset shields 70/72 as shown in FIG. 15.

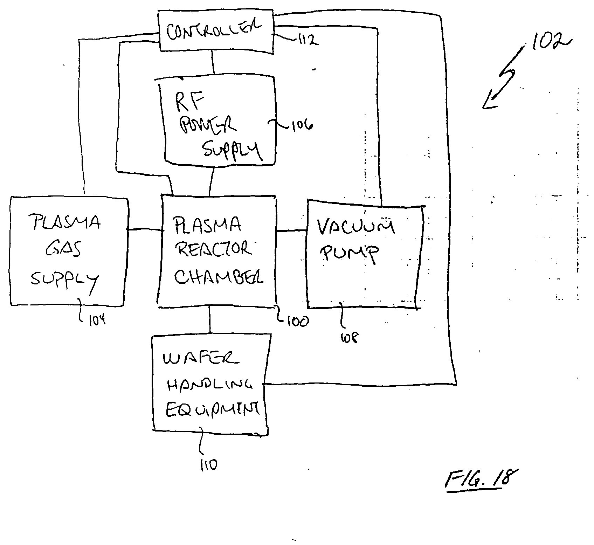

While in these embodiments, antenna 68 is preferably planar, it need not be, and a helical antenna configuration as shown in FIGS. 16 - 17 would also work. As shown in FIGS. 16 - 17 a non-planar RF coil/antenna 86 shaped in the form of a helical coil with the portion adjacent window 84 preferably flattened against window 84 as shown is disposed outside the vacuum chamber. A pair of offset Faraday-sputter shields 88, 90 are disposed within the vacuum chamber adjacent to dielectric window 84. Shield 88 is formed with a plurality of slots 92 which are arranged to be at substantially right angles to the flattened portions 94 of coil 86 when looked at from above coil 86 looking down through window 84, a view as is shown in FIG. 17.

Two requirements exist which apply to the material construction of the shields. First, for minimum power losses due to the addition of the shields, eddy current losses in the shields should be minimized. This is conventionally accomplished by forming the shields of a material with good electrical conductivity (i.e., gold, copper or silver) and a good (very smooth) surface finish for good surface electrical conductivity. Second, the material and surface finish of the shields must promote good adhesion of deposited materials or else there will be a high particulate count in the system. The material used must not contribute contaminants to the system. Typically, such a requirement is met by providing a rough surface finish in order to promote adhesion. The rough surface is typically achieved by abrading the surface with a bead blaster or similar technique. According to the present invention, both of these seemingly contradictory requirements are met at the same time.

According to a presently preferred embodiment of the present invention, the vertically slotted shield 58 in FIGS. 6 - 7 is formed of a material capable of adhering material released during the plasma process. The outer surface 60 of the shield exposed to the exciting coils is given a smooth finish and a smooth coating of a high conductivity material is applied to that face. Where the coils are external to the vacuum chamber, this smooth finish of the shields would be adjacent to the inner wall of the vacuum chamber and facing outward. The inner surface 62 of the shield is roughened as by bead or sand blasting to the extent required by the application. Some applications might not require this step at all, others will.

Another way to fabricate shield 58 is to begin with the shield in the shape desired, give it a smooth finish all over, plate it with a highly electrically conductive material, abrade the unwanted interior coating on inner surface 62 and apply a rough surface to it at that point.

For the disk-type shield embodiment of FIGS. 9 - 17, the disk-type shield 70/72 will have an upper side 80 and a lower side 82 (FIG. 9), the upper side 80 will be adjacent to the dielectric-window 84 through which RF energy from RF coil 68 will come. The upper side 80 may preferably be smooth and coated to enhance surface conductivity as outer surface 60. The lower side 82 may be roughened to enhance adhesion as inner surface 62.

Finally, turning to FIG. 18, as those of ordinary skill in the art will appreciate, a plasma reactor 100 as described above (optionally including a conventional magnetron assembly) is intended to be used in a system 102 including a plasma gas supply 104 (typically Argon), an RF power supply 106 for powering the RF coil, a vacuum pump 108 for controlling the pressure of plasma reactor chamber 100, wafer handling equipment 110 for handling wafers (e.g., conventional mechanisms for loading and unloading wafers into and from the chamber, a conventional wafer table and chuck within the chamber 100, conventional substrate bias power supplies, etc.). A controller or multiple controllers 112 preferably monitor and control the various components of the system in a conventional manner well known to those of ordinary skill in the art. System 102 may also, preferably, be part of a cluster tool device for carrying out several semiconductor process steps, as well known to those of ordinary skill in the art.

While the apparatus has been described in a substrate-on-the-bottom configuration, there is nothing to prevent the apparatus from being constructed so that the substrate being worked on is held with its processed side facing down rather than up as shown. Clamping devices are known in the art which can achieve this orientation.

## Claims

1. A Faraday-sputter shield for use in a plasma processing system, said shield comprising:
a structure having a first surface and a second surface, with at least one slot disposed through said first and second surfaces;
the walls of said structure defining said at least one slot intersecting substantially all line of sight paths between said first and second surfaces.

2. A shield as claimed in claim 1 for use in said plasma processing system which has a plasma confining chamber and an RF coil located outside the chamber, said at least one slot being oriented with respect to said RF coil so as to attenuate most capacitive coupling between said RF coil and a plasma disposed within a plasma forming region within said chamber while not attenuating most inductive coupling between said RF coil and said plasma.

3. A shield as claimed in claim 1 or claim 2 wherein said second surface is treated to enhance adhesion between said second surface and material sputtered from a sputter target.

4. A shield as claimed in any one of claims 1 to 3 wherein said first surface is treated to enhance its electrical conductivity.

5. A shield as claimed in any one of claims 1 to 4 wherein said structure comprises a hollow tubular structure having said second surface disposed inside said tubular structure and said first surface disposed outside said tubular structure, said second surface and said first surface disposed about a central axis, there being a plurality of said slots disposed parallel to said central axis.

6. A shield as claimed in any one of claims 1 to 4 wherein said structure comprises a flat, planar structure having said first surface planar and disposed at one side of said structure and said second surface planar and disposed at an opposite side of said structure.

7. A shield as claimed in claim 5 or claim 6 wherein said first surface is finished with a first finish of a first roughness and said second surface is finished with a second finish of a second roughness, said second roughness being rougher than said first roughness.

8. A plasma reactor comprising:
a plasma confining chamber within which a semiconductor substrate is to be processed, said chamber including an outer wall, at least a portion of said outer wall formed of a dielectric material;
an RF coil located outside said chamber, adjacent to the portion of said outer wall formed of a dielectric material; and
a Faraday-sputter shield as claimed in any one of the preceding claims located inside said chamber and adjacent to the portion of said outer wall formed of a dielectric material, said at least one slot being oriented with respect to said RF coil so as to attenuate most capacitive coupling between said RF coil and a plasma disposed within a plasma forming region within said chamber while not attenuating most inductive coupling between said RF coil and said plasma, the walls of said structure defining said at least one slot intersecting substantially all line of sight paths between a plasma forming region within said chamber and said portion of said outer wall formed of a dielectric material.

9. A reactor as claimed in claim 8 wherein each said slot is oriented perpendicularly to said RF coil.

10. A reactor as claimed in claim 8 or claim 9 further comprising a magnetron sputter target disposed within said chamber.

11. A reactor as claimed in claim 10 further comprising means for rotating magnets of said magnetron sputter target about a vertical axis thereof.

12. A reactor as claimed in any one of claims 8 to 11 further comprising:
a bias power supply for generating a DC bias voltage; and
means for electrically connecting said DC bias voltage to said Faraday-sputter shield.

13. A reactor as claimed in any one of claims 8 to 12 wherein said portion of the outer wall is formed of quartz.

14. A reactor as claimed in any one of claims 8 to 12 wherein said portion of the outer wall is formed of alumina.

15. A reactor as claimed in any one of claims 8 to 14 further comprising a cylindrical, electrically conductive radio frequency interference shield disposed about said RF coil.

16. A reactor as claimed in any one of claims 8 to 15 further comprising a plasma gas supply, a vacuum pump, wafer handling equipment, an RF power supply and a controller.

17. A method of plasma processing a semiconductor substrate comprising the steps of:
enclosing a semiconductor substrate to be plasma processed within the plasma confining chamber of a plasma reactor as claimed in claim 8 or any claim dependent thereon and energizing said RF coil with an RF signal.
